Europäisches Patentamt

European Patent Office

Office européen des brevets

(19)

(11) Publication number: **0 094 685**

**B1**

(12)

# EUROPEAN PATENT SPECIFICATION

(45) Date of publication of patent specification: **28.09.88**

(21) Application number: **83104910.1**

(22) Date of filing: **18.05.83**

(51) Int. Cl.⁴: **H 02 J 7/14,** H 02 J 7/16, G 01 R 31/36

(54) **Charge control microcomputer arrangement for vehicle.**

(30) Priority: **18.05.82 JP 85204/82**

(43) Date of publication of application:
**23.11.83 Bulletin 83/47**

(45) Publication of the grant of the patent:
**28.09.88 Bulletin 88/39**

(84) Designated Contracting States:
**DE FR GB**

(56) References cited:
**EP-A-0 010 449
GB-A-2 052 121
GB-A-2 068 660
US-A-3 676 770**

**COMPUTER DESIGN, vol. 19, no. 5, May 1980,
CONCORD (US) S. GROVES: "Controllers come
to age", pages 86, 91, 94, 98, 100, 102, 106. 108,
109.**

(73) Proprietor: **MITSUBISHI DENKI KABUSHIKI
KAISHA
2-3, Marunouchi 2-chome Chiyoda-ku
Tokyo 100 (JP)**

(72) Inventor: **Morishita, Mitsuharu c/o Mitsubishi
Denki K. K.
Himeji Works No. 840, Chiyoda-cho
Himeji-shi Hyogo (JP)**
Inventor: **Kouge, Shinichi c/o Mitsubishi Denki
K.K.
Himeji Works No. 840, Chiyoda-cho
Himeji-shi Hyogo (JP)**

(74) Representative: **Lehn, Werner, Dipl.-Ing. et al
Hoffmann, Eitle & Partner Patentanwälte
Arabellastrasse 4
D-8000 München 81 (DE)**

EP 0 094 685 B1

## Description

This invention relates to a charge control microcomputer arrangement for a vehicle. Such a device may externally provide a predetermined value for a voltage regulator adapted to control the output voltage of a charging generator installed in the vehicle or the like and driven by the internal combustion engine thereof, and which is capable of troubleshooting the system according to data received from the charging system.

An apparatus for charging a vehicle battery is known from EP—A—0 010 449 which comprises an engine driven AC-generator having armature coils and a field coil, a battery, a voltage regulator and a microcomputer. The microcomputer computes an ideal reference charging voltage on the basis of data received from a plurality of sensors which detect such parameters as battery temperature, charge condition and specific gravity. As a result, the operation of the generator is adjusted so that the charging voltage produced is equal to the reference charging voltage, thereby increasing the battery lifetime.

In general, in a conventional device of this type, the output voltage of a generator driven by a vehicle engine is controlled to a predetermined value which is preset by the voltage regulator installed together with the generator. The output voltage thus controlled charges the battery of the vehicle. In this connection, the voltage regulator may include a temperature compensating circuit if the case requires, so as to prevent difficulty if the battery charging characteristic changes with temperature.

The generator is driven by an internal combustion engine as described above. Therefore, the conventional device is disadvantageous, in that, when the aforementioned predetermined value is controlled during the acceleration or deceleration of the engine or according to the speed of rotation thereof to control the mechanical load of the engine, i.e. the generator drive output, it is difficult to externally control the output. Also, it is difficult, if not impossible, to estimate the service life of the battery.

It is known from US—A—3 676 770 to determine the internal resistance of a battery by employing as a load a train of pulses the duration of which is about ten milliseconds.

An object of this invention is to provide a charge control microcomputer device for a vehicle, in which at least some of the above described difficulties have been eliminated or at least reduced, and in which the internal resistance of the battery can be determined more readily.

According to the invention, there is provided a charge control microcomputer arrangement for a vehicle, comprising an AC generator for being driven by an engine, said generator having armature coils and a field coil; a battery charged by a rectified output of said generator; a voltage regulator for controlling the current in said field coil, to control an output voltage of said generator to a predetermined value; a charge control microcomputer for setting a reference voltage for said voltage regulator according to battery terminal voltage data and generated voltage data, and for detecting failures according to data received from various points in a charge system thereof; and a display unit for displaying results of detection of said charge control microcomputer, characterized

—in that an engine controlling microcomputer (8) for receiving engine data from said engine (11) is provided to control said engine directly connected to said charge control microcomputer (6) such that said charge control microcomputer (6) can receive at least one of said engine data from said engine control microcomputer (8),

—in that said charge control microcomputer measures the internal resistance of said battery (4) on the basis of the data from said charge-discharge current sensor (13) and said battery terminal voltage data upon starting of said engine (11).

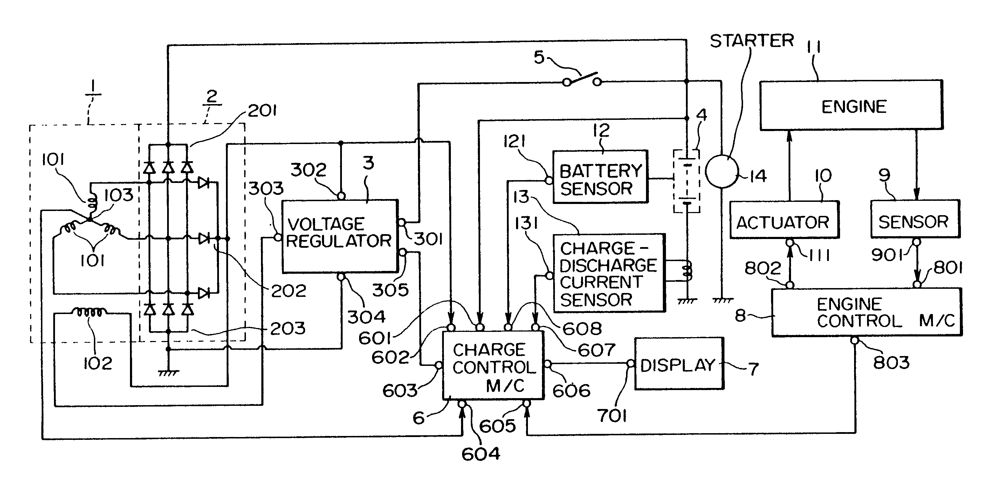

The single figure in the accompanying drawing is an electrical circuit diagram showing one example of a charge control microcomputer device for a vehicle according to one embodiment of this invention.

One embodiment of the charge control microcomputer device according to the invention will be described by way of example with reference to the single figure of the accompanying drawing. This figure illustrates an engine 11 installed on a vehicle or the like; a three-phase AC generator 1 driven by the engine, the generator 1 having three-phase star-connected armature coils 101, a field coil 102 and a neutral point 103 at which generated voltage data is provided; a full-wave rectifier 2 for subjecting the AC output of the generator 1 to full-wave rectification, the rectifier 2 having a first rectifier output terminal 201, a second rectifier output terminal 202 and a ground terminal 203; a voltage regulator 3 for controlling the field current in the field coil 102, to control the output voltage of the generator 1; an initial excitation terminal 301; a voltage detection terminal 302; a field coil terminal 303; a ground terminal 304; and an external control input terminal 305. Further, the figure illustrates a battery 4 which provides battery terminal voltage data, a key switch 5; a charge control microcomputer 6 which processes at least one of data from an engine controlling microcomputer 8 (described later), the battery terminal voltage data and the generated voltage data, detects problems according to the data from the charging system, such as the battery terminal voltage, the neutral point voltage data, battery sensor data, and charge-discharge current data, and transmits the detected results to a display unit 7; a battery voltage input terminal 601; a second rectifier output terminal 602 (from voltage input terminal 202); a reference signal output terminal 603 through which an external control reference signal is applied to the external control input terminal 305 of the voltage regulator 3; an input terminal 604 for receiving the neutral point voltage of the generator 1; an input terminal 605 for receiving data from the engine controlling microcomputer 8; an output terminal 606 through which a display signal is applied to the display unit 7; a charge-discharge current input terminal 607; and an input terminal 608 for receiving data from a battery sensor 12, which may detect such parameters as the battery solution temperature, acidity, etc.

Furthermore, the figure illustrates the aforementioned display unit 7 for displaying a troubleshooting result; a display signal input terminal 701; the aforementioned engine controlling microcomputer 8; an input terminal 801 for receiving a signal from a sensor 9 (described later); an engine control signal output terminal 802; an output terminal 803 through which data is applied to the charge control microcomputer 6; a sensor signal output terminal 901; an actuator 10 for receiving a control signal from the microcomputer 8, to mechanically drive a part of the engine 11, a control signal input terminal 111; the aforementioned battery sensor 12; a battery sensor data output terminal 121; a charge-discharge current sensor 13; a charge-discharge current output terminal 131; and a starter 14.

The operation of the device, which is arranged as described above, will now be described.

When the engine 11 is started, first the key switch 5 is closed. As a result, a circuit consisting of the battery 4, the key switch 5, the initial excitation terminal 301 of the voltage regulator 3, the voltage detection terminal 302, the field coil 102, the field coil terminal 303 and the ground terminal 304 is completed, so that an initial excitation current flows in the field coil 102, and a field magnetomotive force is generated. In this operation, the voltage of the battery 4 is applied through the key switch 5 to the microcomputers 6 and 8 and, when necessary, to the display unit 7, the sensor 9, the actuator 10, the battery sensor 12 and the charge-discharge current sensor 13, to operate these circuit elements. Therefore, data of the engine 11 is detected by the sensor 9, and coverted into an electrical signal. The engine data may include data such as the intake air temperature, the r.p.m., the crank angle, exhaust gas temperature, the air fuel ratio, etc. The electrical signal is applied through the sensor signal output terminal 901 to the sensor input terminal 801 of the engine controlling microcomputer 8, where it is processed. As a result, the microcomputer 8 provides a control signal which places the engine 11 in an optimum state for starting. The control signal is applied through the engine control signal output terminal 802 to the control signal input terminal of the actuator 10, to drive the latter, so that the engine is placed in the most suitable state for starting. The engine controlling microcomputer 8 applies the data from the sensor 9 through the data output terminal 803 to the data input terminal 605 of the charge control microcomputer 6. The charge control microcomputer 6 processes the engine data and the charge system data, to provide a predetermined value for the voltage regulator which is best for starting the engine 11. The predetermined value is applied to the reference signal output terminal 603.

When, under this condition, the engine 11 is started by the starter 14 to drive the generator 1, an AC output is induced in the armature coils 101 according to the speed of the generator 1 and is subjected to full-wave rectification in the full-wave rectifier 2. As the voltage regulator 3 carries out the on-off control of the field current in the field coil 102, the output voltage of the rectifier 2 is controlled to the reference voltage provided by the charge control microcomputer 6. The charge control microcomputer 6 processes the engine data from the engine controlling microcomputer 8 and the charge system data, during the operation of the engine 11, to apply the reference voltage which is most suitable for the engine 11 and the charge system, to the voltage regulator 3 through the refernece signal output terminal 603.

When, under the above-described conditions, problems such as non-generation, non-control and disconnection of the first rectifier output terminal 201 occur in the charge system, the charge control microcomputer 6 performs internal processing using the data corresponding to the voltage of battery 4, the voltage at the second rectifier output terminal 202 and the voltage at the neutral point 103, which are applied respectively through the terminals 601, 602 and 603 to detect the failure. The result of detection is applied through the display signal output terminal 606 to the display unit 7, where it is displayed.

The internal resistance of the battery 4 is measured by utilizing the data from the charge-discharge current sensor 13 and the terminal voltage of the battery 4 when the starter is operated. Following this, data from the battery sensor 12 may be taken into account to enable the remaining service life of the battery to be estimated. Where this is done the result is transmitted to the display unit 7, where it is displayed.

As described above in detail, in the device of the invention, the charge control microcomputer internally processes at least one of the engine data from the engine controlling microcomputer and the charge system data such as the battery terminal voltage data and the generated voltage data, to apply the optimum reference voltage to the voltage regulator. Therefore, the reference voltage provided is the most suitable for charging the battery, and the mechanical load can be readily controlled during acceleration or deceleration of the engine.

Since the service life of the battery can be estimated before it becomes unserviceable according to the invention, the battery may be replaced by a new one before the occurrence of a problem where the engine cannot be started because of an unserviceable battery.

In the above-described embodiment, the generated voltage data is detected at the neutral point 103 of the armature coil 101; however, the same effect can be obtained by detecting the voltage at the second rectifier output terminal 202 or a one-phase output terminal of the armature coils 101.

## Claims

1. A charge control microcomputer arrangement for a vehicle comprising:

an AC generator (1) for being driven by an engine (11), said generator having armature coils (101) and a field coil (102);

a battery (4) charged by a rectified output of said generator (1);

a voltage regulator (3) for controlling the current in said field coil (102), to control an output voltage of said generator to a predetermined value;

a charge control microcomputer (6) for setting a reference voltage for said voltage regulator (3) according to battery terminal voltage data and generated voltage data, and for detecting failures according to data received from various points in a charge system thereof;

a display unit (7) for displaying results of detection of said charge control microcomputer; and characterized

—in that an engine controlling microcomputer (8) for receiving engine data from said engine (11) is provided to control said engine directly connected to said charge control microcomputer (6) such that said charge control microcomputer (6) can receive at least one of said engine data from said engine control microcomputer (8),

—in that said charge control microcomputer measures the internal resistance of said battery (4) on the basis of the data from a charge-discharge current sensor (13) and said battery terminal voltage data upon starting of said engine (11).

2. An arrangement as claimed in claim 1, characterized in that said data received from said charge system includes at least said battery terminal voltage data, the voltage at one output terminal of a generator rectifier (2), and the voltage at a selected point of said armature coils (101).

3. A vehicle having an engine (11) characterized by a charge-control microcomputer arrangement according to claims 1 or 2.

## Patentansprüche

1. Ladekontrolleinrichtung mit Mikrocomputer für eine Fahrzeug, umfassend:

einen durch einen Motor (11) angetriebenen Wechselstromgenerator (1), wobei der Generator Ankerspulen (101) und eine Feldspule (102) aufweist,

eine Batterie (4), welche durch ein gleichgerichtetes Ausgangssignal des Generators (1) geladen wird,

einen Spannungsregler (3) zur Steuerung des Stroms in der Feldspule (102), um eine Ausgangsspannung des Generators auf einen vorbestimmten Wert zu steuern,

einen Ladekontroll-Mikrocomputer (6) zum Einstellen einer Referenzspannung für den Spannungsregler (3) entsprechend Batterieanschlußspannungsdaten und erzeugten Spannungsdaten und zur Ermittlung von Fehlern entsprechend den von unterschiedlichen Punkten im Ladesystem erhaltenen Daten,

eine Anzeigeeinheit (7) zur Anzeige von Ermittlungsergebnissen des Ladekontroll-Mikrocomputers, dadurch gekennzeichnet,

—daß ein Motorkontroll-Mikrocomputer (8) zum Empfangen von Motordatan aus dem Motor (11) ausgebildet ist, um dem Motor, der mit dem Ladesteuer-Mikrocomputer (6) direkt verbunden ist, derart zu steuern, daß der Ladesteuer-Mikrocomputer (6) mindestens ein Datensignal der Motordaten des Motorkontroll-Mikrocomputers (8) empfangen kann,

—daß der Ladekontroll-Microcomputer den Innenwiderstand der Batterie (4) auf der Basis der Daten von einem Lade-Entlade-Sstromsensor (13) und der Batterieanschlußspannungsdaten beim Starten des Motors (11) mißt.

2. Einrichtung nach Anspruch 1, dadurch gekennzeichnet, daß die Daten, die vom Ladesystem empfangen werden, zumindest die Batterieanschlußspannungsdaten, die Spannung an einem Ausgangsanschluß eines Generatorgleichrichters (2) und die Spannung an einem ausgewählten Punkt der Ankerspulen (101) umfassen.

3. Fahrzeug mit einem Motor (11) gekennzeichnet durch eine Lade-Kontroll-Mikrocomputereinrichtung nach Anspruch 1 oder 2.

## Revendications

1. Dispositif de contrôle de charge avec micro-calculateur pour un véhicule comprenant:

un générateur de courant alternatif (1) destiné à être entraîné par un moteur (11), le générateur comportant des enroulements d'induit (101) et une bobine de champ (102);

une batterie (4) chargée par un signal de sortie redressé du générateur (1);

un régulateur de tension (3) pour régler le courant dans la bobine de champ (102), afin de régler la tension de sortie du générateur à une valeur prédéterminée;

un micro-calculateur de contrôle de charge (6) pour établir une tension de référence pour le régulateur de tension (3) selon des données de tension de bornes de batterie et des données de tension engendrée, et pour détecter des pannes selon les données reçues de différents points dans son système de charge;

une unité d'affichage (7) pour afficher les résultats de la détection du micro-calculateur de contrôle de charge; et caractérisé

—en ce qu'un micro-calculateur de contrôle de moteur (8) destiné à recevoir des données de moteur du moteur (11) est prévu pour contrôler le moteur directement connecté au micro-calculateur de contrôle de charge (6) de telle sorte que le micro-ordinateur de contrôle de charge (6) peut recevoir au moins une des données de moteur du micro-calculateur de contrôle de moteur (8),

—en ce que le micro-calculateur de contrôle de charge mesure la résistance interne de la batterie (4) en fonction des données provenant d'un capteur de courant de charge-décharge (13) et des données de tension de bornes de batterie au démarrage du moteur (11).

2. Dispositif selon la revendication 1, caractérisé en ce que les données reçues du système de charge comprennent au moins les données de tension de bornes de batterie, la tension à une borne de sortie d'un redresseur de générateur (2), et la tension à un point sélectionné des enroulements d'induit (101).

3. Véhicule comportant un moteur (11) caractérisé par un dispositif à micro-calculateur de contrôle de charge selon l'une quelconque des revendications 1 ou 2.